Europäisches Patentamt

European Patent Office

Office européen des brevets

(11) Publication number: **0 508 408 A2**

# EUROPEAN PATENT APPLICATION

(21) Application number: **92106078.6**

(22) Date of filing: **08.04.92**

(51) Int. Cl.5: **H01L 23/485**

(30) Priority: **08.04.91 JP 73477/91**

(43) Date of publication of application:
**14.10.92 Bulletin 92/42**

(84) Designated Contracting States:
**DE FR GB**

(71) Applicant: **NEC CORPORATION**
**7-1, Shiba 5-chome Minato-ku**
**Tokyo 108-01(JP)**

(72) Inventor: **Kono, Hiromichi**
**c/o NEC Corporation, 7-1, Shiba 5-chome**
**Minato-ku, Tokyo(JP)**

(74) Representative: **Glawe, Delfs, Moll & Partner**
**Patentanwälte**
**Postfach 26 01 62**
**W-8000 München 26(DE)**

(54) **Semiconductor device having metallization layers.**

(57) A semiconductor device comprises a semiconductor substrate 1 formed with a diffusion layer; a first level gold-metallization layer 2 formed on the semiconductor substrate; a first inter-layer insulating film 3 formed on the first level metallization layer 1; a second level Au-metallization layer 4 formed on the first insulating film 3; a second inter-layer insulating film 5 formed on the second level metallization layer; and a third level gold-metallization layer formed on the second insulating film 5. As the diameter or short side of the through hole 3a is smaller than twice the film thickness of the second gold-metallization 4, gold grows isotropically from the wall surface of the through-hole, and at the time when deposition thickness reaches half the short side of the through-hole, the through-hole can be completely filled with gold and the gold-deposition surface becomes even.

According to the present invention, steps caused by a through-hole formed in an inter-layer film can be completely filled with metallizing material. This makes it possible to form another through-hole just over the through-hole, or separated metallization contacts just over the through-hole. Therefore, device element can be highly integrated thus markedly improving quality and production yield.

FIG. 2

## BACKGROUND OF THE INVENTION

### 1. Field of the Invention

This invention relates to a semiconductor device, and more particularly, to a semiconductor device having a multi-layer metallization structure.

### 2. Description of the Prior Art

In the conventional semiconductor devices, Aluminum or Aluminum alloys have been widely used as wiring material. However, as the semiconductor integrated circuits become highly integrated, wiring metallization is required to be multi-layered. This demand exposes drawbacks of the metallization of aluminum which has a relatively small atomic weight. More specifically, failures such as electro-migration and/or stress migration are brought about and this limits the life of metallization.

Generally, aluminum is deposited by a vacuum evaporation process or a sputtering process, so that the coating around steps is liable to present insufficiency. On the other hand, if steps are provided with inclination at their side in order to improve the coating performance, this makes it difficult to better the integration, thus causing paradoxical problems.

To solve these problems, application of gold-metallization becomes of more importance. By using gold, resistance to the electoro-migration and/or stress migration are improved one order of magnitude higher than that of aluminum, and the coating performance is bettered remarkably.

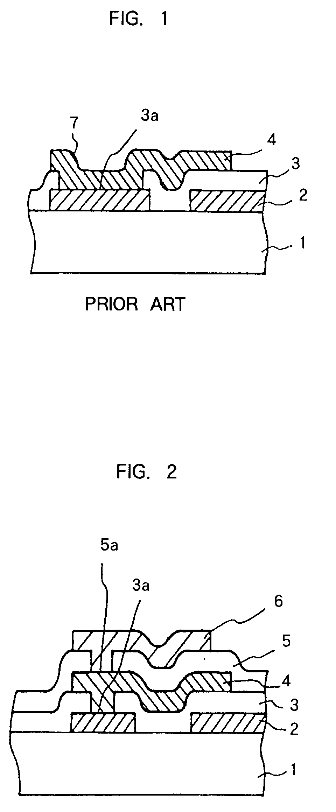

A multi-layer metallization structure according to prior art will now be described by reference to Fig. 1.

On a silicon substrate 1 with a first level gold-metallization 2 formed thereon, there is formed a first inter-layer insulating film 3, on which a second level gold-metallization 4 is formed. As is apparent from Fig.1, the layer of the second level gold-metalization 4 is formed with a step 7 which reflects on the uneveness of the first level gold-metallization 2 having a through-hole 3a therein.

This uneveness makes difficult the pattern formations of the inter-layer insulating film around the step 7 and the gold-metallization thereon, thus reducing the production yield and quality.

As stated above, a mere replacement of Aluminum-metallization by gold-metallization can not achieve a sufficient effect. That is, a step due to a through-hole can not be filled and evened by gold-deposition unless the dimension of the step is properly related with the thickness of gold-metallization. Accordingly, pattern formation of the upper level metallization and through-holes cannot be performed perfectly due to the reflection on uneven surface in align-exposure process. Moreover, the conductor film for gold-current path cannot be removed completely, thus giving rise to drawbacks that reduce production yield and quality.

## SUMMARY OF THE INVENTION

It is an object of the present invention to provide a semiconductor device in which a through-hole formed on an inter-layer insulating layer is filled and deposited with a metallization so as not to form steps or unevenness.

According to the present invention, there is provided a semiconductor device which comprises: a semiconductor substrate; a first level metallization layer formed on a major surface of the semiconductor substrate; a first insulating film formed on the first level metallization layer; a second level metallization layer made of either gold or gold-alloy, formed on the first insulating film; and a second insulating film formed on the second level metallization layer; a third level metallization layer formed on the second insulating film; a through-hole disposed in the first insulating film for electrically interconnecting between the first level metallization layer and the second level metallization layer, having a shape of rectangle with its short side being smaller than twice the thickness of the second level metallization layer.

## BRIEF DESCRIPTION OF THE DRAWINGS

Fig.1 is a cross-sectional view showing a multi-level metallization structure according to prior art;
Fig.2 is a cross-sectional view showing a first embodiment of the present invention; and
Fig.3 is a cross-sectional view showing a second embodiment of the present invention.

## DETAILED DESCRIPTION OF PREFERRED EMBODIMENTS

The present invention will now be described in detail with reference to accompanying drawings.

Fig.2 shows an elemental structure of a semiconductor device as a first embodiment according to the present invention.

On a silicon substrate 1 subjected to diffusion steps, there is provided a first level gold-metallization 2. An inter-layer insulating film 3 made of silicon nitride is provided on this first level gold-metallization 2. Further, on the insulating film 3, there are formed with layers, that is, a second level gold-metallization 4, a second inter-layer insulating film 5 made of silicon nitride and a third level gold-deposition 6 in this order.

Here, a first through-hole 3a is formed in the first inter-layer insulating film 3. This through hole 3a has a rectangular shape with its short side being smaller than twice the film-thickness of the second level gold-metallization 4. For instance, if gold-metallization film has a thickness of 1$\mu$ m, a suitable short side length of the through-hole 3a may be 1.5$\mu$ m.

With this condition, when an gold-metallization is formed by gold-deposition, gold grows isotropically from the wall surface of the through-hole 3a, and at the time when deposition thickness reaches half the short side of the through-hole 3a, the through-hole 3a is completely filled with gold and the gold-deposition surface becomes even.

According to the present invention, the metallized surface over a through-hole can be completely formed even, so that a second through-hole 5a can be easily formed just over the first through-hole 3a. Here this second through-hole 5a is to have a rectangle shape.

In this manner, a second inter-layer 5, a second through-hole 5a and a third level gold-metallization 6 are formed, so as to complete a device element section of a semiconductor device made of three layers of gold-metallization. It is suitable to use an gold-metallization of 1$\mu$ m thick for each metallization layer, and a silicon nitride film of 1$\mu$ m thick for each inter-layer insulating film. A through-hole is suitably 1.5$\mu$ m in its short side length.

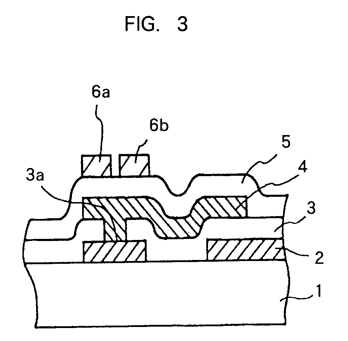

Next will be followed a description on a second embodiment of the present invention referring to Fig.3.

In Fig.3, the same reference numerals designate the same constituents as shown in Fig.2, so that explanations will not be repeated.

In this embodiment, no second through-hole is formed over the first through-hole 3a, and instead third level gold-metallization contacts 6a and 6b are formed which are different in type of electric connection from the first embodiment. In this embodiment, since an inter-layer insulating film 5 over the through-hole 3a is formed even, it is possible to easily form metallization contacts 6a and 6b close to each other on the insulating film 5 over the through-hole 3a.

According to the present invention, steps cansed by a through-hole formed in an inter-layer insulating film can be completely filled with a metallizing material formed as an upper layer of the inter-layer. The metallization layer just over a through-hole can be formed even, so that it is possible to form another through-hole, or separate metallization contacts just over the through-hole.

As a result, it is possible to have a device highly integrated, thus realizing a sharp improvement in quality and production yield.

In the first and second embodiments detailed above, the through-hole 3a formed in the first inter-layer insulating film 3 is of a shape of a rectangle. However, the shape of a through-hole may be square or circle. In these cases, if the length of the side of a square, or the diameter of a circle should be smaller than twice the film thickness of the second level metallization layer 4, the same effect can be obtained.

## Claims

1. A semiconductor device comprising:
   a semiconductor substrate;
   a first level metallization layer formed on a major surface of said semiconductor substrate;
   a first insulating film formed on said first level metallization layer;
   a second level metallization layer formed on said first insulating film; and
   a first through-hole disposed in said first insulating film for electrically inter-connecting between said first level metallization layer and said second level metallization layer, said through-hole having a shape of rectangle with its short side being smaller than twice the thickness of said second level metallization layer.

2. A semiconductor device according to claim 1; further comprising:
   a second insulating film formed on said second level metallization layer;
   a third level metallization layer formed on said second insulating film; and
   a second through-hole disposed in said second insulating film just over said first through-hole for electrically interconnecting between said second level metallization layer and said third level metallization layer, having the same structure as said first through-hole.

3. A semiconductor device according to claim 1 further comprising:
   a second insulating film formed on said second level metallization layer; and
   a pair of third level metallization contacts arranged closely to each other on said second insulating film just over said first through-hole.

4. A semiconductor device according to claim 1 wherein said second level metallization layer consists of gold or gold-alloy.

5. A semiconductor device comprising:
   a semiconductor substrate;
   a first level metallization layer formed on a major surface of said semiconductor substrate;

a first insulating film formed on said first level metallization layer;

a second level metallization layer formed on said first insulating film; and

a first through-hole disposed in said first insulating film for electrically inter-connecting between said first level metallization layer and said second level metallization layer, said through-hole having a shape of square with its side being smaller than twice the thickness of said second level metallization layer.

6. A semiconductor device comprising:

a semiconductor substrate;

a first level metallization layer formed on a major surface of said semiconductor substrate;

a first insulating film formed on said first level metallization layer;

a second level metallization layer formed on said first insulating film; and

a first through-hole disposed in said first insulating film for electrically inter-connecting between said first level metallization layer and said second level metallization layer, said through-hole having a shape of circle with its diameter being smaller than twice the thickness of said second level metallization layer.

FIG. 1

PRIOR ART

FIG. 2

FIG. 3